# DEMANDE DE BREVET EUROPEEN

(11) **EP 1 548 847 A2**
(43) Date de publication de la demande: **29.06.2005**
(21) Numéro de dépôt: 04292972.9
(22) Date de dépôt: 13.12.2004
(51) Int. Cl.: H01L 31/05, H01L 31/042, B64G 1/44

(54) **Panneau de générateur solaire et satellite associé**

(30) Priorité: 23.12.2003 FR 0315227; 02.02.2004 FR 0450181
(71) Demandeur: ALCATEL, 75008 Paris (FR)
(72) Inventeur: Boulanger, Bernard, 83600 Frejus (FR); Delclos, Hubert, 06330 Roquefort-les-Pins (FR)
(74) Mandataire: Fournier, Michel Robert Marie

(57) **Abrégé**

Un panneau générateur solaire comprenant un réseau plan de chaînes de cellules photovoltaïques disposées côte à côte.

Selon l'invention, les cellules sont rognées sur leurs bords, permettant de générer un espace libre dans l'interstice entre les rognures.

Il est alors possible d'y placer des ouvertures pour y passer des câbles et/ou d'y placer des cales amortissantes.

Application particulière aux panneaux solaires pour satellites.

## Description

La présente invention est relative, d'une manière générale, au domaine des panneaux générateurs d'énergie solaire, notamment pour applications spatiales. Elle concerne, plus particulièrement, un panneau générateur solaire comprenant un réseau de chaînes de cellules photovoltaïques disposées côte à côte et formant sensiblement un quadrillage.

Les panneaux générateurs solaires transportés dans un véhicule spatial, tel qu'un satellite, comprennent en général :
- un réseau de cellules solaires formées de chaînes de cellules ("strings" en anglais) connectées électriquement au satellite, ce réseau recouvrant la surface de panneaux de support et destiné à transformer l'énergie solaire en énergie électrique,
- lesdits panneaux de support des réseaux de cellules, comprenant un substrat.

De tels panneaux générateurs solaires peuvent être répartis selon des configurations très diverses. Il s'agit classiquement d'une succession longitudinale, parallèle à une direction s'éloignant du corps du véhicule spatial et autour de laquelle le panneau générateur est destiné à tourner pour suivre le soleil. Toutefois, pour augmenter la puissance électrique disponible, il a été proposé de disposer, en plus des panneaux précédents, des panneaux supplémentaires latéraux. On connaît aussi des configurations dans lesquelles les panneaux sont disposés selon une direction transversale, c'est à dire selon une direction transversale à la direction longitudinale précitée selon laquelle s'étend l'étrier ou bras d'éloignement ("yoke" en anglais) qui relie le générateur au corps du satellite, et autour de laquelle le générateur est adapté à tourner pour suivre le soleil.

Un autre facteur d'augmentation de la puissance électrique disponible des panneaux réside dans le taux de remplissage des cellules solaires au sein du panneau. Il est courant d'utiliser des cellules au silicium, qui permettent d'atteindre un taux de remplissage de 0.94, jugé excellent. Bien entendu, cet excellent résultat provient du nombre peu élevé de chaînes par panneau caractéristique des chaînes de cellules au silicium, engendrant des pertes en surface faibles.

Cependant, la recherche s'oriente désormais de plus en plus vers l'utilisation de cellules GaAs, qui procurent un taux de conversion énergétique élevé.

Malgré tout, plusieurs contraintes s'élèvent face à l'utilisation des cellules GaAs :
- il faut tout d'abord trouver la solution à la connexion des multiples bornes positives et négatives des chaînes de cellules, solution qui puisse optimiser l'espace occupé pour ces bornes,
- d'autre part, il est connu que, si la tension entre les cellules voisines est plus élevée qu'un certain seuil, le courant utile de la chaîne peut alors circuler entre les deux cellules via un plasma créé par une décharge électrostatique primaire. Cet arc secondaire entretenu par le courant utile du générateur peut être maintenu pendant quelques secondes ou plus. Il apparaît alors que cet arc secondaire dissipe suffisamment d'énergie pour chauffer le substrat isolant, et ce jusqu'à une température telle que le polymère de résistance élevée se transforme en matériau de très faible résistance. Ce processus de pyrolyse entraîne un court circuit permanent entre les deux cellules, et donc entre les deux rangées de cellules adjacentes, ce qui cause la destruction permanente d'une partie du générateur solaire, incapable de délivrer toute la puissance utile aux équipements du satellite.

Pour les panneaux dans lesquels les bornes +, - des chaînes de cellules se trouvent sur le même bord du panneau, usuellement qualifiés à configuration en "U" (en anglais "U-shape"), deux bornes +, - qui sont associées à un même "U" sont relativement proches et ont une différence de potentiel qui vaut la chute de tension de toute la chaîne correspondante. Ainsi, la différence de potentiel maximale apparaît entre ces bornes successives, et entre les deux cellules contiguës qui sont chacune à une extrémité d'une même chaîne en "U". Il en découle que la faible distance qui sépare ces cellules (ou ces bornes) associée à une forte différence de potentiel constitue un risque d'apparition d'arc électrique tel qu'expliqué ci-dessus.

C'est la raison pour laquelle on est obligé d'imposer une tension maximum entre cellules voisines (de l'ordre de 40 V).

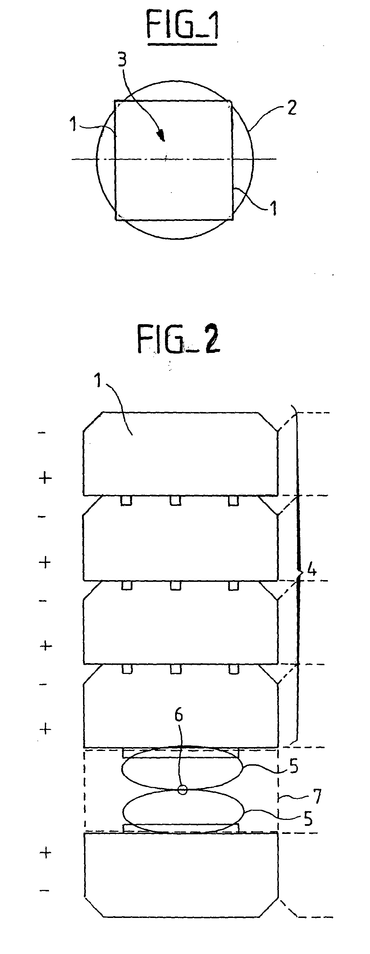

Par ailleurs, une méthode pour réduire les risques de décharge secondaire entre rangées adjacentes réside dans l'augmentation de l'intervalle entre rangées de cellules. Toutefois, l'espace ainsi créé entraîne une diminution du taux de remplissage du panneau en cellules et grève alors la puissance collectrice d'énergie solaire du panneau. En effet, dans l'état actuel des connaissances, le taux de remplissage des cellules GaAs plafonne entre 0.90 et 0.92. Ce taux est notamment atteint en utilisant des cellules obtenues par le procédé, tel qu'illustré sur la figure 1, de découpe des cellules 1 au sein de disques 2 de Germanium Ge 5 (terme couramment utilisé "wafer"), mettant en évidence la rognure des sommets des deux cellules 1. Les fournisseurs de cellules 1 ont notamment pris l'habitude de couper le carré 3 en deux pour fournir les deux cellules rectangulaires à sommets rognés sur deux des leurs à partir d'un même disque 2.

La figure 2 illustre les chaînes 4 de cellules utilisées de nos jours. La chaîne 4 est constituée de cellules 1 solaires connectées en série deux à deux, formant ainsi une rangée de cellules. Les extrémités de la chaîne 4, qui peuvent se trouver sur la même rangée ou sur des rangées différentes, sont chacune connectées à une borne +, - du panneau, pour que le courant électrique fourni par chaque chaîne soit collecté par des cablâges 5 et conduit, via des ouvertures 6 dédiées et un câblage installé sur la face arrière, en direction des équipements du satellite. Cependant, la surface 7 dédiée aux câbles 5, à leurs connexions aux cellules terminales et à l'ouverture de connexion, correspond généralement à la surface d'une cellule, voire plus, grèvant ainsi considérablement le taux de remplissage du panneau.

L'invention a donc pour but un panneau générateur solaire comprenant un réseau plan de chaînes de cellules solaires, qui résolve les inconvénients cités ci-dessus en permettant de réduire la surface perdue pour les connexions des bornes des chaînes avec le satellite, et les risques de tension différencielle entre cellules voisines.

A cet effet, la présente invention a pour objet un panneau générateur solaire comprenant un réseau de chaînes de cellules photovoltaïques disposées côte à côte et formant sensiblement un quadrillage sur une première face du panneau dite face avant, lesdites cellules étant électriquement connectées selon une pluralité de chaînes indépendantes, chaque chaîne étant constituée de cellules connectées en série deux à deux formant des rangées de cellules parallèles les unes aux autres, deux rangées successives d'une chaîne étant électriquement connectées par leurs extrémités via des moyens de connexions traversant le panneau par des premières ouvertures et plaqués sur la face arrière, chaque chaîne comprenant des bornes positives et des bornes négatives, lesdites bornes positives et négatives étant réparties le long de chaque chaîne et sur la surface du panneau pour que les bornes positives soient éloignées des bornes négatives, afin de diminuer un risque d'apparition d'arc électrique entre deux bornes, chaque cellule terminale d'une chaîne étant connectée à au moins un câble collecteur d'énergie électrique passant par au moins une ouverture respective de rassemblement de câbles collecteurs dite seconde ouverture, caractérisé en ce que les cellules sont de surface carrée ou rectangulaire et sont rognées sur leurs quatre sommets, l'agencement des cellules sous forme de quadrillage faisant apparaître, suite auxdites rognures des sommets, des espaces libres réduits dans les interstices entre rognures de cellules voisines, espaces dans lesquels sont créées les premières ouvertures et les secondes ouvertures de rassemblement des câbles collecteurs, vers lesquels ces derniers sont dirigés.

Selon un mode de réalisation, dans au moins un desdits espaces libres dans les interstices entre rognures de cellules voisines a été aménagée au moins une cale amortissante inter-panneaux.

Selon un mode de réalisation, les cellules sont fabriquées en utilisant un procédé de découpe d'une tranche de Germanium Ge.

Selon un mode de réalisation, les connexions électriques entre deux cellules voisines successives sont réalisées en face arrière de l'une d'elles et à proximité d'au moins une de ses rognures.

L'invention a également pour objet un satellite, caractérisé en ce qu'il comporte un panneau générateur solaire selon l'invention.

D'autres caractéristiques et avantages de l'invention apparaîtront plus clairement à la lecture de la description suivante des exemples particuliers de réalisation en référence aux figures suivantes :
- la figure 1 schématise le procédé de découpe des cellules,
- la figure 2 illustre les chaînes de cellules telles que combinées dans l'état de la technique,
- la figure 3 schématise un réseau plan de cellules selon un premier mode de réalisation de l'invention,
- la figure 4 illustre un autre mode de réalisation de l'invention,
- la figure 5 schématise un réseau plan de cellules octogonales selon une variante de la figure 3.

Les éléments exerçant une fonction identique ou similaire porteront dans la suite la même référence.

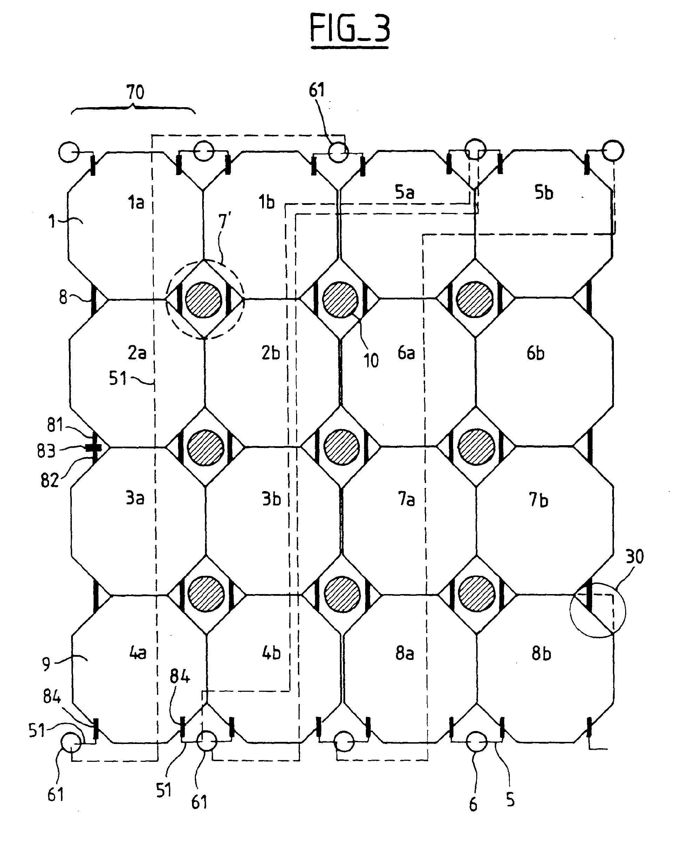

La figure 3 schématise un réseau plan 100 de cellules octogonales selon un premier mode de réalisation de l'invention.

Pour une meilleure clarté dans la distinction des différentes chaînes de cellules, il n'a été illustré que deux chaînes de cellules, la première comportant les cellules référencées de 1 a à 8a alors que la seconde comporte les cellules référencées de 1 b à 8b.

L'ordre de numérotation correspond à la continuité électrique réalisée. Ainsi, deux cellules successives d'une même chaîne sont reliées par une connexion 8. En fait, cette connexion est composée de deux sous-connexions 81, 82, chacune étant solidaire à l'une des deux cellules successives, les deux sous-connexions étant soudées l'une à l'autre au niveau d'un point de jonction 83.

Le point de jonction 83 a été illustré, sur la figure 3, de manière à rendre les deux sous-connexions 81, 82 équivalentes en longueur. Cependant, selon une variante préférée d'assemblage des cellules, l'une des deux sous-connexions de la première cellule se prolonge jusque sous la cellule à laquelle elle doit être assemblée pour y être soudée. On comprend aisément que, selon cete variante préférée, non représentée, le point de jonction peut être sous l'une des deux cellules, au lieu d'être à mi-chemin entre les deux cellules.

On notera que les liaisons électriques en face avant sont illustrées en traits pleins alors que les liaisons en face arrière sont réalisées en traits pointillés. On notera également que la jonction 83 peut être réalisée par tout autre moyen connu de l'Homme du Métier que par la soudure.

Ainsi qu'il en ressort de la figure 3, la cellule terminale 4a de la rangée 70 comporte des sous-connexions 84 qui sont reliées, par des fils de connexion 51 traversant des ouvertures 61 et plaqués contre la face arrière du panneau, à la cellule 5a via l'ouverture 61 logée dans son espace libre associé. On remarquera que la cellule 5a est au bord opposé de celui de la cellule 4a.

Comme on le constate, les rognures 30 sur les sommets des cellules ont permis de créer un espace 7' libre réduit permettant d'y placer les connexions 8.

Ces connexions dans l'espace réduit créé permettent également grâce à l'invention de réduire la tension différentielle entre cellules voisines.

En outre, dans les espaces libres ne comportant ni les ouvertures de rassemblement des câbles collecteurs ni les ouvertures permettant de relier deux cellules terminales, a été aménagée des cales 10 amortissantes inter-panneaux. Chacune des cales 10 est collée sur l'endroit indiqué par un disque rempli de rayures en face du disque en regard du panneau avec lequel le présent panneau est empilé selon une direction normale aux plans des panneaux. Ces cales ont pour fonction d'amortir et d'absorber les chocs inter-panneaux en phase de lancement ainsi qu'en phase de vol.

Ainsi, grâce à l'invention, on a augmenté la zone disponible pour le montage des cales amortissantes et une meilleure répartition de ceux-ci est réalisée, sans nécessité de suppression de cellules pour le montage des cales amortissantes.

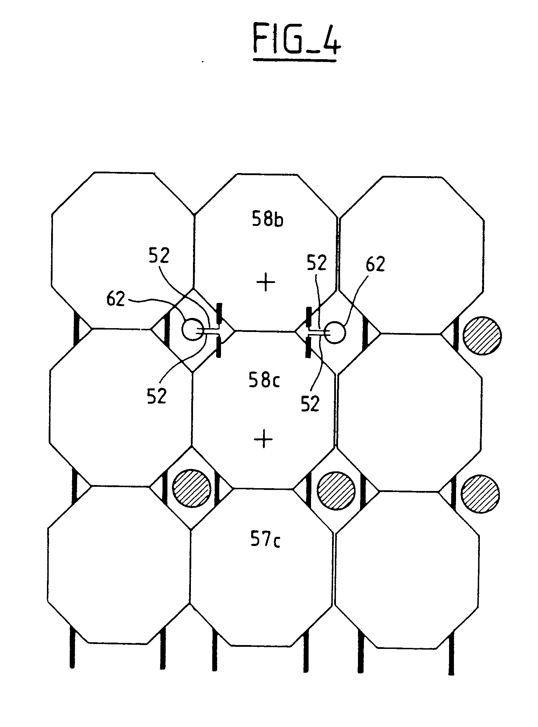

La figure 4 illustre un mode de réalisation de l'invention où une cellule terminale 58c d'une chaîne est contigue à une autre cellule 58b contigue d'une autre chaîne. Des câbles 52 reliés chacun à une borne des cellules terminales 58b et 58c sont reliés à une ouverture 62 pour être dirigés vers le satellite.

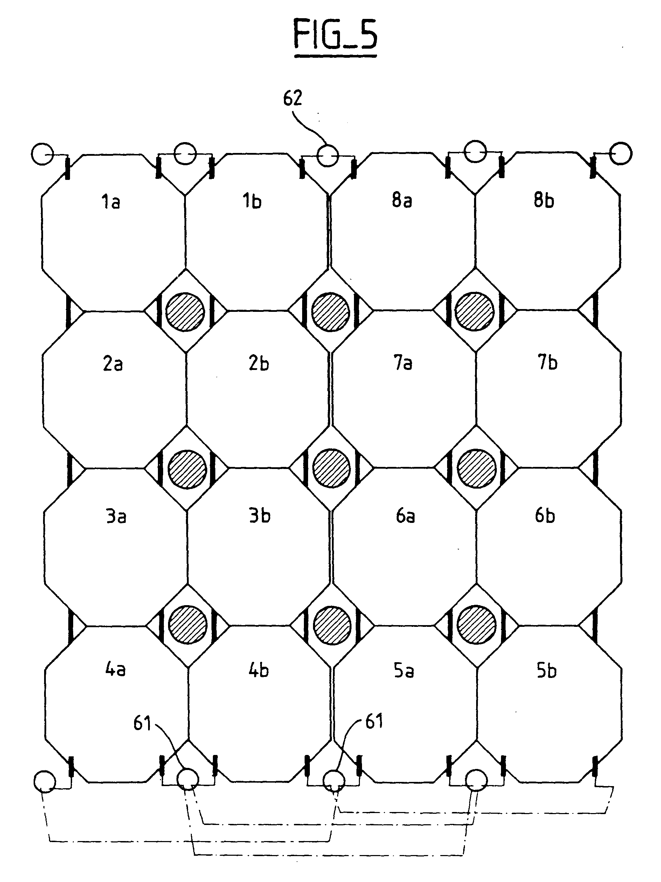

La figure 5 schématise un réseau plan de cellules octogonales selon une variante de la figure 3.

En effet, la connexion entre deux cellules terminales 4a et 5a, respectivement 4b et 5b, d'une même chaîne se fait sur le même bord. Comme on le remarque, les connexions passent tout de même par des ouvertures 61 pour être plaquées sur une partie de leur chemin sur la face arrière du panneau.

Bien entendu, l'invention n'est pas limitée aux modes de réalisation décrits dans la présente demande.

Par exemple, l'invention n'est pas limitée à un réseau plan de chaînes de cellules mais pourrait s'appliquer à des surfaces cylindriques avec un rayon de courbure suffisamment grand pour y appliquer des cellules souples.

## Revendications

1. Panneau générateur solaire comprenant un réseau (100) de chaînes (4 ; 1a-8a ; 1b-8b) de cellules (1) photovoltaïques disposées côte à côte et formant sensiblement un quadrillage sur une première face du panneau dite face avant, lesdites cellules étant électriquement connectées selon une pluralité de chaînes (4) indépendantes, chaque chaîne étant constituée de cellules connectées en série deux à deux formant des rangées (70) de cellules parallèles les unes aux autres, deux rangées successives d'une chaîne étant électriquement connectées par leurs extrémités via des moyens de connexions (51) traversant le panneau par des premières ouvertures (61) et plaqués sur la face arrière, chaque chaîne comprenant des bornes positives (+) et des bornes négatives (-), lesdites bornes positives et négatives étant réparties le long de chaque chaîne et sur la surface du panneau pour que les bornes positives soient éloignées des bornes négatives, afin de diminuer un risque d'apparition d'arc électrique entre deux bornes, chaque cellule terminale (1a,8a,1b,8b) d'une chaîne étant connectée à au moins un câble (52) collecteur d'énergie électrique passant par au moins une ouverture respective de rassemblement de câbles collecteurs dite seconde ouverture (62), **caractérisé en ce que** les cellules sont de surface carrée ou rectangulaire et sont rognées sur leurs quatre sommets (30), l'agencement des cellules sous forme de quadrillage faisant apparaître, suite auxdites rognures des sommets, des espaces (7') libres réduits dans les interstices entre rognures de cellules voisines, espaces dans lesquels sont créées les premières ouvertures et les secondes ouvertures de rassemblement des câbles collecteurs, vers lesquels ces derniers sont dirigés.

2. Panneau selon la revendication 1, **caractérisé en ce que**, dans au moins un desdits espaces libres dans les interstices entre rognures de cellules voisines a été aménagée au moins une cale amortissante inter-panneaux.

3. Panneau selon la revendication 1 ou 2, **caractérisé en ce que** les cellules sont fabriquées en utilisant un procédé de découpe d'une tranche de Ge.

4. Panneau selon l'une des revendications 1 ou 2, **caractérisé en ce que** les connexions électriques entre deux cellules voisines successives d'une même chaîne sont réalisées en face arrière de l'une d'elles et à proximité d'au moins une de ses rognures.

5. Satellite, **caractérisé en ce qu'**il comporte un panneau générateur solaire selon l'une des revendications 1 à 4.
